# EUROPEAN PATENT SPECIFICATION

(11) **EP 4 087 129 B1**
(45) Date of publication and mention of the grant of the patent: **16.09.2026**
(21) Application number: 20909776.5
(22) Date of filing: 06.05.2020
(51) Int. Cl.: H03H 9/02, H03H 9/17

(54) **BULK ACOUSTIC RESONATOR AND RESONATOR SET PROVIDED WITH ACOUSTIC INTERFERENCE ARRAYS, AND FILTER AND ELECTRONIC DEVICE**
VOLUMENWELLENRESONATOR UND RESONATORSATZ MIT AKUSTISCHEN INTERFERENZARRAYS, FILTER UND ELEKTRONISCHES GERÄT
RÉSONATEUR ACOUSTIQUE EN VOLUME ET ENSEMBLE RÉSONATEUR POURVU DE RÉSEAUX D'INTERFÉRENCES ACOUSTIQUES, ET FILTRE ET DISPOSITIF ÉLECTRONIQUE

(30) Priority: 31.12.2019 CN 201911419008
(43) Date of publication of application: 09.11.2022
(73) Proprietor: Rofs Microsystem (Tianjin) Co., Ltd, Tianjin 300462 (CN)
(72) Inventor: PANG, Wei, Tianjin 300072 (CN); YANG, Qingrui, Tianjin 300072 (CN); ZHANG, Menglun, Tianjin 300072 (CN)
(74) Representative: Meyer-Dulheuer MD Legal Patentanwälte PartG mbB
(86) International application number: PCT/CN2020/088731
(87) International publication number: WO 2021/135021

(56) References cited:
- CN-A- 103 401 528
- CN-A- 107 196 618
- CN-A- 109 459 144
- CN-A- 109 889 178
- CN-A- 109 889 179
- CN-A- 110 061 712
- CN-A- 111 092 605
- JP-A- 2007 184 816
- US-A1- 2012 161 902
- US-A1- 2012 182 092
- US-B1- 10 389 392
- US-B1- 7 939 987

## Description

### TECHNICAL FIELD

The present disclosure relates to the field of semiconductors, and in particular, to a bulk acoustic wave resonator, a bulk acoustic wave resonator assembly, a filter, and an electronic device.

### BACKGROUND

As basic elements of an electronic apparatus, electronic devices have been widely applied, and their applications cover mobile phones, automobiles, home appliances and the like. In addition, technologies such as artificial intelligence, Internet of Things and 5G communication that will change the world in the future still need and rely on the electronic devices.

As an important member of the piezoelectric devices, a Film Bulk Acoustic Resonator (FBAR, also referred to as a bulk acoustic wave resonator (BAW)) is very important in the field of communication, and especially, an FBAR filter has gained a growing market share in the field of radio frequency filters. The traditional surface acoustic wave (SAW) filters and ceramic filters are gradually replaced by the FBAR filters due to their small size, high resonant frequency, high quality factor, large power capacity, good roll-off effect, and other excellent characteristics. Such the FBAR filters are used widely in the field of wireless communication radio frequency, and can be also applicable to the sensing filed such as biology, physics, and medicine due to their high sensitivity.

The film bulk acoustic resonator mainly includes a "sandwich" structure composed of electrode-piezoelectric film-electrode, i.e., the piezoelectric material is sandwiched between the two metal electrodes. When a sinusoidal signal is input between the two electrodes, the FBAR converts an input electrical signal into a mechanical resonance through an inverse piezoelectric effect, and then converts the mechanical resonance into an electrical signal output by the piezoelectric effect.

With increasingly high performance requirements of 5G filters, a Q value of the bulk acoustic wave resonator needs to be continuously improved to meet this development demand.
US 2012 161 902 A1 discloses an solid mount bulk acoustic wave resonator, comprising a substrate, an acoustic mirror, a bottom electrode, a top electrode and a piezoelectric layer provided between the bottom electrode and the top electrode; the acoustic resonator comprises bridge along the interconnection side, the cantilevered portion may also be referred to as a wing. However, US 2012 161 902 A1 fails to disclose the distinguishing features in the characterizing part of claim 1.
US 2012 182 092 A1 discloses an acoustic wave device in which each of frequency control films like islands (referred to as island patterns) is provided, as multiple independent patterns, on the upper electrode in at least the membrane portion in which the upper electrode and the lower electrode face each other. Each of the island patterns has an identical size. Therefore, since the frequency control film with the hole patterns is the smallest mass, and the frequency control film with the hole patterns is the largest mass, the resonance frequency of the resonator may be adjusted by appropriately selecting any of the frequency control films.
US 7 939 987 B1 discloses an acoustic wave device in which transducers and resonators may include periodically placed obstacles formed as strips of reflective material aligned generally perpendicular to the electrodes.
JP 2007 184 816 A discloses a bulk acoustic wave resonator provided with a piezoelectric substance laminated on a support frame, a bottom electrode formed on the support frame, and a top electrode; in which several holes are established in the area surrounded on the outer periphery of the top electrode.

### SUMMARY

In order to alleviate or solve at least one aspect of above problems in the related art, the present disclosure is provided.

According to an aspect of embodiments of the present disclosure, there is provided a bulk acoustic wave resonator that includes a substrate, an acoustic mirror, a bottom electrode, a top electrode, and a piezoelectric layer. The piezoelectric layer is arranged between the bottom electrode and the top electrode. The top electrode, the piezoelectric layer, the bottom electrode and the acoustic mirror overlap with each other in a thickness direction of the resonator to form an overlapping region, and the overlapping region is an effective region of the resonator. An edge of the effective region of the resonator is provided with an acoustic mismatch structure which is a border ring providing an acoustic mismatch at the perimeter of the upper electrode. A top surface of the resonator is provided with an acoustic interference array which is an array of protrusions or recesses. The acoustic interference array includes a central array covering the effective region and a peripheral array covering at least part of the acoustic mismatch structure. At least one of the central array and the peripheral array comprises at least two types of array structures, the at least two types of array structures comprise a first array structure and a second array structure. Centers of first array elements of the first array structure form a first point array, centers of second array elements of the second array structure form a second point array, the second point array is a point array obtained by planar rotation or planar translation relative to the first point array, and adjacent array elements of the first array elements and the second array elements are spaced apart from each other; and the first array elements have a size different from a size of the second array elements.

An embodiment of the present disclosure also relates to a bulk acoustic wave resonator assembly including at least two bulk acoustic wave resonators as described above. An inter-resonator array is provided between opposite sides of two adjacent bulk acoustic wave resonators of the at least two bulk acoustic wave resonators, and the inter-resonator array is an array formed by protrusions and/or recesses.

An embodiment of the present disclosure also relates to a filter including the bulk acoustic wave resonator or the resonator assembly as described above.

An embodiment of the present disclosure also relates to an electronic device including the filter, the resonator, or the resonator assembly as described above.

### BRIEF DESCRIPTION OF DRAWINGS

The following description and drawings can facilitate to understand these and other features and advantages in various embodiments disclosed in the present disclosure. The same reference signs in the drawings always indicate the same components, and in which:
FIG. 1A is a schematic top view of a bulk acoustic wave resonator according to an exemplary embodiment of the present disclosure;
FIG. 1B is a schematic top view illustratively showing a peripheral array comprises an array which is provided around the bulk acoustic wave resonator of FIG. 1A;
FIG. 1C is a schematic sectional view showing a part of the bulk acoustic wave resonator along line A1-A1 in FIG. 1A according to an exemplary embodiment of the present disclosure;
FIG. 2A is a schematic enlarged diagram illustratively showing a portion ROI1 of FIG. 1A;
FIG. 2B is a schematic enlarged diagram illustratively showing a portion ROI2 of FIG. 1A;
FIG. 3A is a schematic top view showing a polygonal ring having an acoustic interference array according to an embodiment of the present disclosure;
FIG. 3B is a schematic top view showing a polygonal ring having an acoustic interference array according to an embodiment of the present disclosure;
FIG. 3C is a schematic top view showing an acoustic interference array provided at an effective region according to an embodiment of the present disclosure;
FIG. 4A is a structural diagram illustratively showing an element of an array;
FIG. 5 is a schematic top view illustratively showing a plurality of bulk acoustic wave resonators adjacently arranged, in which an acoustic interference array provided between resonators and each respectively arranged between opposite sides of adjacent ones of the resonators;
FIG. 6A is a schematic diagram illustratively showing a first array structure and a second array structure combined with each other;
FIG. 6B is a schematic diagram illustratively showing a first array structure and a second array structure combined with each other;
FIG. 7A is a schematic diagram illustratively showing a first array structure and a second array structure combined with each other;
FIG. 7B is a schematic diagram illustratively showing a first array structure and a second array structure combined with each other;
FIG. 7C is a schematic diagram illustratively showing a first array structure and a second array structure combined with each other;
FIG. 8A is a schematic diagram illustratively showing a first array structure, a second array structure and a third array structure combined with each other; and
FIG. 8B is a schematic diagram illustratively showing a first array structure, a second array structure and a third array structure combined with each other.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure.

The present disclosure provides a bulk acoustic wave resonator including an acoustic interference array that is arranged on a top surface of the bulk acoustic wave resonator, in which the top surface of the bulk acoustic wave resonator includes a top surface of an effective region and at least part of an acoustic mismatch structure region. Accordingly, acoustic performance of the resonator is further improved.

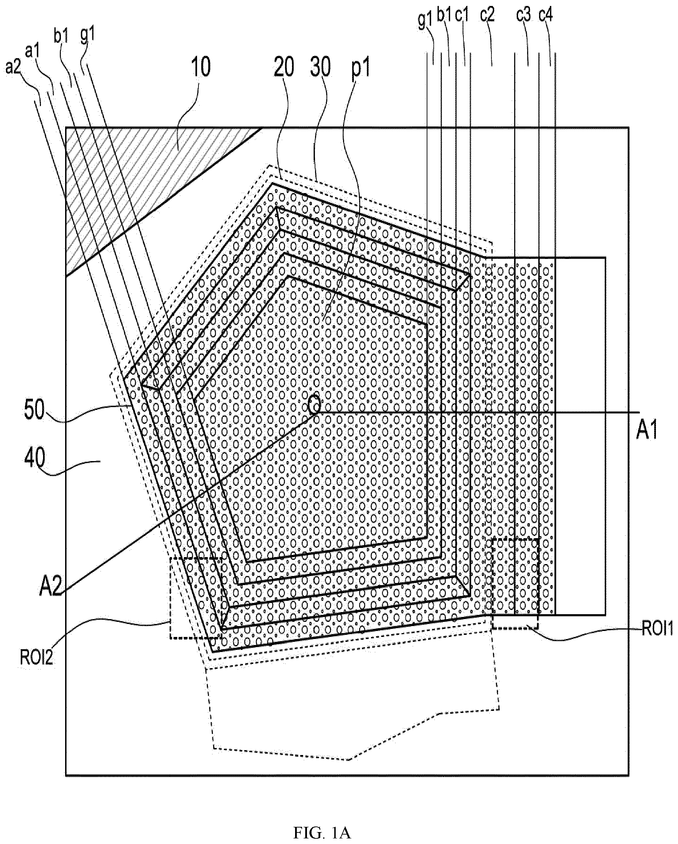

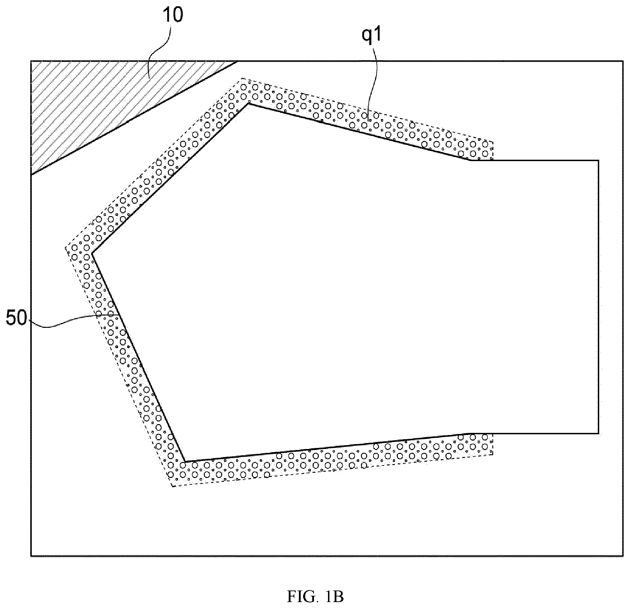

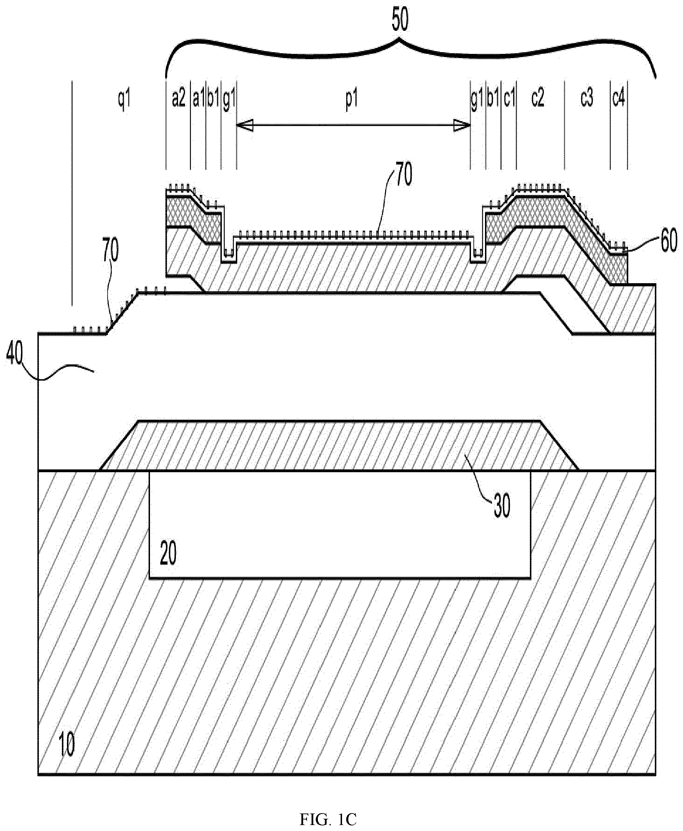

FIG. 1A is a schematic top view of a bulk acoustic wave resonator according to an exemplary embodiment of the present disclosure, FIG. 1B is a schematic top view illustratively showing a peripheral array comprises an array which is provided around the bulk acoustic wave resonator of FIG. 1A, and FIG. 1C is a schematic sectional view of a part of the bulk acoustic wave resonator along line A1-A1 in FIG. 1A according to an exemplary embodiment of the present disclosure. Reference numbers are illustrated as follows.

10: Substrate, which is made of a material such as monocrystalline silicon, gallium arsenide, sapphire, and quartz.

20: Acoustic mirror, which may be a cavity, or can adopt a Bragg reflection layer and other equivalent forms.

30: Bottom electrode, which may be made of a material such as molybdenum, ruthenium, gold, aluminum, magnesium, tungsten, copper, titanium, iridium, osmium, chromium, or composite or alloys thereof.

40: Piezoelectric film layer or piezoelectric layer, which may be made of a material such as aluminum nitride (AlN), zinc oxide (ZnO), lead zirconate titanate (PZT), lithium niobate (LiNbO₃), quartz, potassium niobate (KNbO₃), or lithium tantalate (LiTaO₃), or the like, and may also contain the above materials doped with a certain atomic ratio of rare earth element.

50: Top electrode, which may be made of a material such as molybdenum, ruthenium, gold, aluminum, magnesium, tungsten, copper, titanium, iridium, osmium, chromium, or composite or alloys thereof.

60: Passivation layer, which may be made of aluminum nitride, silicon dioxide, silicon nitride, metal oxide, or metal nitride.

70: Acoustic interference array, which may be a protrusion or recess. The array may be located on a surface of the passivation layer as shown in FIG. 1C, or may be directly formed on the top electrode 50 and a surface (such as, a surface of the protrusion or a wing) of the acoustic structure arranged on the top electrode.

In the embodiments shown in FIGS. 1A to 1C, the array 70 is distributed in following regions that are divided based on the acoustic structure:
a1: an ascending inclined portion of a wing structure;
c1: an ascending inclined portion of a bridge structure where a1 and c1 form a polygonal annular region;
a2: a horizontal portion of the wing structure;
c2: a horizontal portion of the bridge structure where a2 and c2 form a polygonal annular region;
b1: a protrusion structure (forming an annular region);
g1: a recess structure (forming an annular region);
c3: a descending inclined portion of the bridge structure;
c4: a portion between the descending inclined portion and an electrode pin;
p1: a portion of the top electrode 50 located at an inner side of the recess annular region; and
q1: a region outside a top-view projection of a profile of the entire top electrode 50 (including the bridge and the wing), as shown in FIG. 1B;
wherein ascending refers to the direction of extending from the bottom electrode to the top electrode, and descending refers to the direction of extending from the top electrode to the bottom electrode.

A specific arrangement of the acoustic interference array 70 is shown in FIGS. 1A and 1B, wherein the acoustic mismatch structure is a border ring providing an acoustic mismatch at the perimeter of the upper electrode, and the acoustic interference array is an array of protrusions or recesses. An array direction is determined and the array is intercepted by boundaries of the resonator. The interception is achieved in such a manner that elements of the array located completely within a certain boundary are maintained and elements of the array located outside the boundary or located partially within the boundary are excluded.

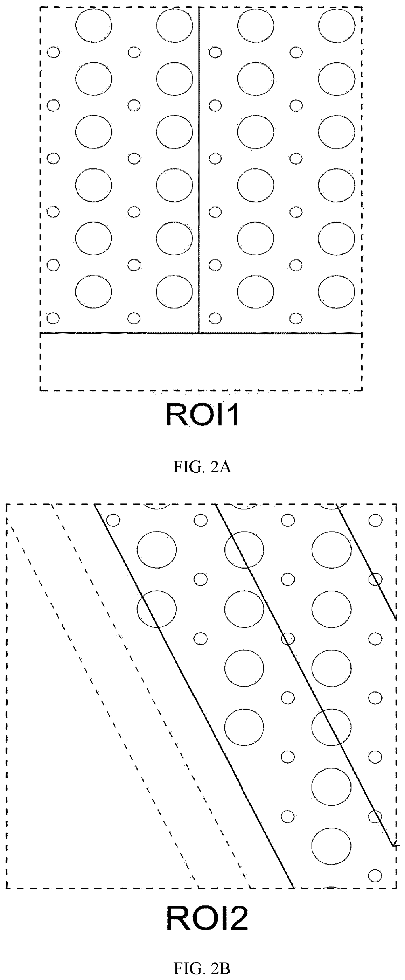

However, the above arrangement has following problems. When an arrangement direction of the elements of the array is parallel to a certain boundary of the resonator (as shown in FIG. 2A, which corresponds to a region ROI1 of FIG. 1A), the elements of the array are maintained completely along the boundary. When the arrangement direction of the elements of the array is arranged at an angle relative to a certain boundary of the resonator (as shown in FIG. 2B, which corresponds to a region ROI2 of FIG. 1A), the elements of the array may be excluded since they cannot fall completely within the boundary, resulting in element loss.

A segmented arrangement of the elements of the array is used to alleviate the above problem. That is, the regions of the array are divided into blocks and the array direction is adjusted for different a part of the blocks, instead of intercepting regions of the whole resonator in a common array. In the present disclosure, the array direction herein denotes an arrangement direction of the array elements of the array parallel to a side of a region or block region.

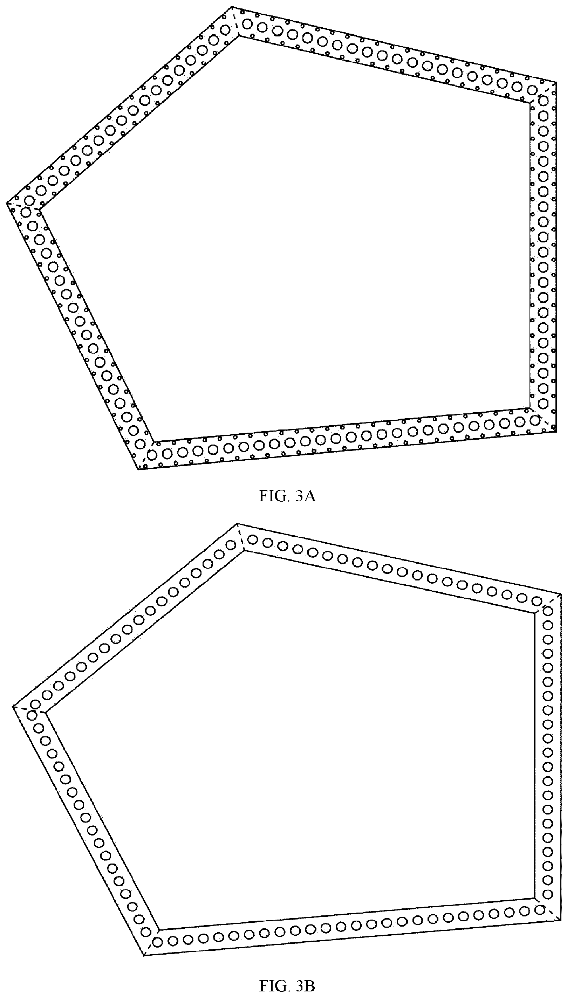

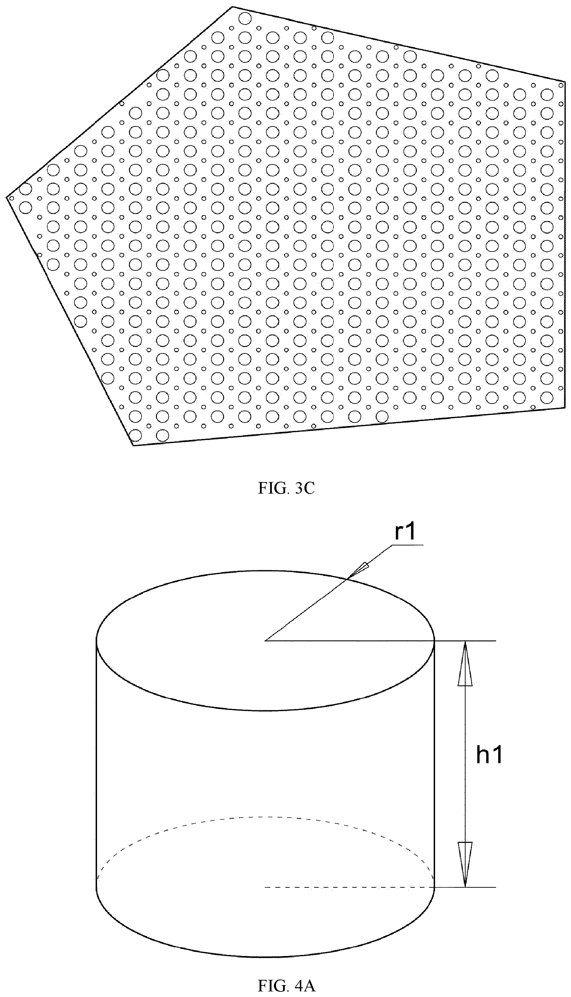

For example, the polygonal annular region shown in FIG. 3A may be divided into five trapezoidal regions as shown in the figure and the array direction is set for each of the regions, such that the array direction is parallel to a bottom side of each of the five trapezoidal regions, thereby significantly reducing the element loss. FIG. 3B shows a special example of the arrangement in FIG. 3A. That is, a single-row array is arranged in each of the trapezoidal regions. However, when an array with a Cartesian coordinate topology is adopted, there is no dividing way for the p1 region to significantly reduce the element loss. Therefore, the array element arrangement in the p1 region is disposed in the original manner, as shown in FIG. 3C. FIGS. 3A to 3C are a schematic top view illustratively showing a polygonal ring where an acoustic interference array is arranged, a schematic top view illustratively showing a polygonal ring where an acoustic interference array is arranged, and a schematic top view illustratively showing an acoustic interference array provided at an effective region, respectively.

FIG. 4A is a structural diagram illustratively showing an element of an array. As shown in FIG. 4A, the element of the array may be a cylindrical protrusion or recess, and a radius of the cylinder is r1 and a height or depth is h1.

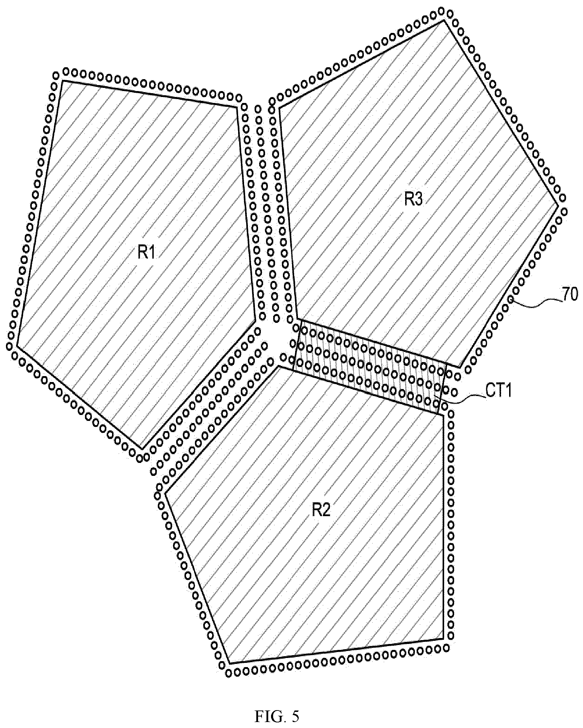

FIG. 5 is a schematic top view illustratively showing a plurality of bulk acoustic wave resonators that are adjacently arranged, in which an inter-resonator acoustic interference array are provided between opposite sides of adjacent ones of the resonators. When a plurality of resonators in the present disclosure constitute filters or other electronic device, array elements located in the q1 region (on the surface of the piezoelectric layer) of each of the filters jointly form the arrangement in FIG. 5. When an electrical connection (CT1) is provided between top electrodes of the resonators, for example the top electrodes of R2 and R3), the array is distributed on a surface of this connection structure and there is no array distributed on an upper surface of the piezoelectric layer covered by the connection structure.

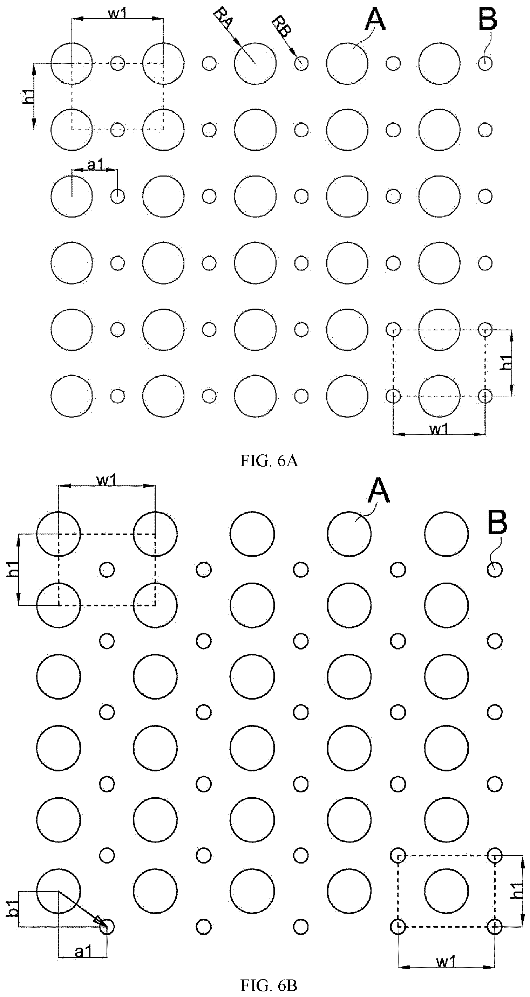

A composite array structure that can be applied to the acoustic interference array of the present disclosure is described below with reference to FIGS. 6A to 8B. It should be noted that, although the composite array structure is described, the acoustic interference array in the present disclosure can be a single array, which both fall within the scope of the present disclosure.

FIG. 6A is a schematic diagram illustratively showing a first array structure and a second array structure that are combined together, and FIG. 6B is a schematic diagram illustratively showing a first array structure and a second array structure that are combined together. In FIGS. 6A and 6B, the two array structures are translated relative to each other, and the arrays in FIGS. 6A and 6B are both rectangular arrays.

In FIG. 6A, subarrays A and B are combined into the array of FIG. 6A by horizontally translating a center of the subarray B with respect to a center of the subarray A by a distance a1.

FIG. 6B is a schematic diagram illustratively showing a first array structure and a second array structure that are combined together. The translation of the subarray B relative to the subarray A is not limited to be obtained in a horizontal direction. As shown in FIG. 6B, the subarray B may be translated relative to the sub-array A by the distance a1 in the horizontal direction and by a distance b1 in a vertical direction. In this figure, h1 denotes a distance between array points in the vertical direction, and w1 denotes a distance between array points in the horizontal direction.

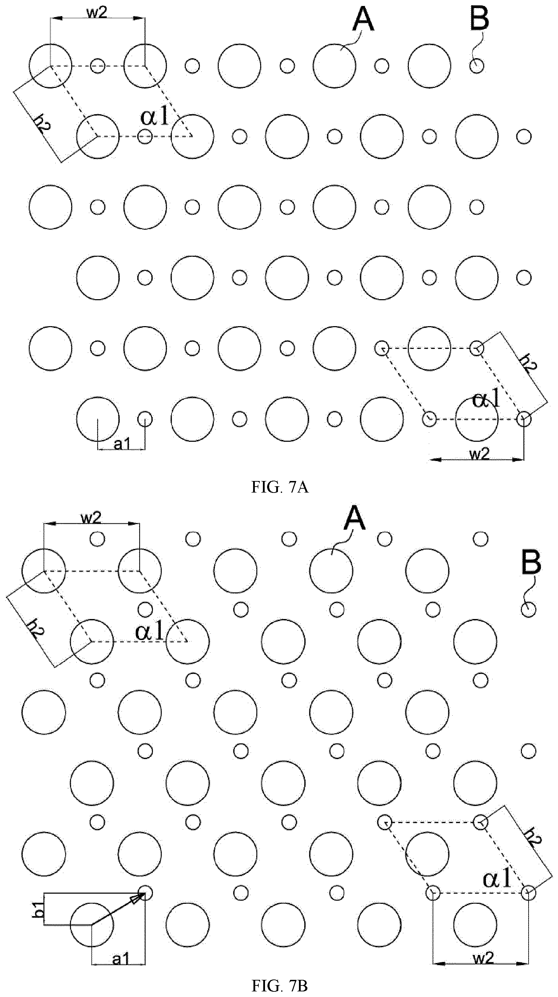

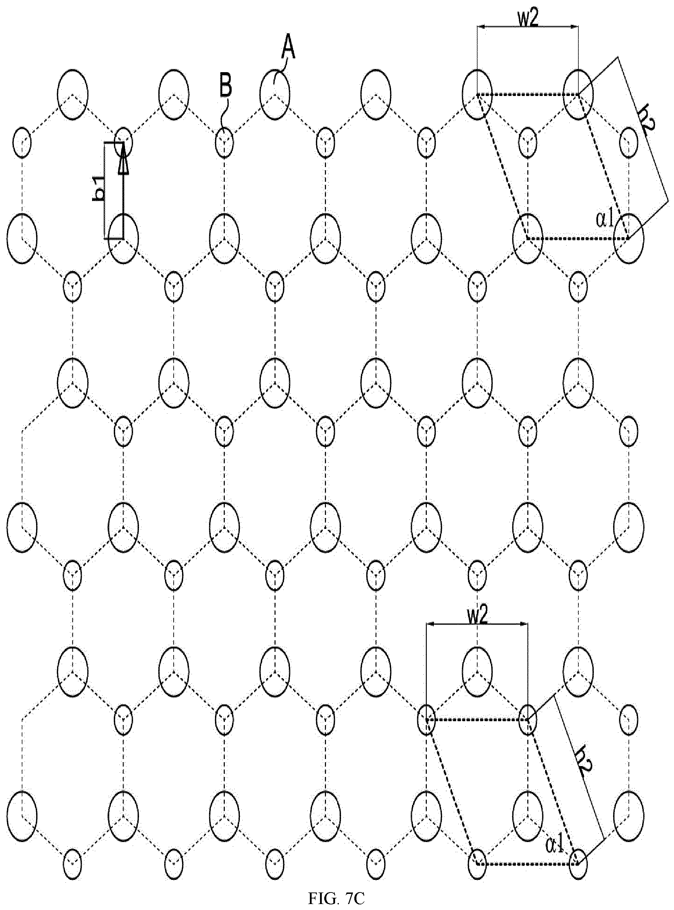

FIG. 7A is a schematic diagram illustratively showing a first array structure and a second array structure that are combined together, FIG. 7B is a schematic diagram illustratively showing a first array structure and a second array structure that are combined together, and FIG. 7C is a schematic diagram illustratively showing a first array structure and a second array structure that are combined together. In FIGS. 7A to 7C, each of the arrays is a staggered array.

In the array of FIG. 7A, centers of four adjacent elements of subarrays A or B are arranged on four vertices of a parallelogram, respectively. Two adjacent sides of the parallelogram have lengths of w2 and h2, respectively, and a sharp angle between the two adjacent sides is α1. The array of FIG. 7A is obtained by horizontally moving a center of an element of the array B relative to a center of an element of the array A by a distance a1.

In the array A of FIG. 7A, among two adjacent rows of array elements arranged in a first direction (a lateral direction in FIG. 7A), two adjacent array elements in one row of the two adjacent rows are adjacent to two adjacent array elements in the other row of the two adjacent rows and these four array elements are four vertices defining a rhombus.

A vertical translation distance b1 is involved based on the translation mode of FIG. 7A to obtain the array of FIG. 7B.

When the above parallelogram is a special rhombus, i.e. w2=h2 and α1=60 degrees, an array mode shown in FIG. 7C can be obtained if the center of the element of the array B is moved upright relative to the center of the element of the array A by a certain distance b1, in which b1 satisfies $b 1 = \frac{w 2}{\sqrt{3}}$. Elements of the array A and the array B are distributed at intervals on vertices of a regular hexagon.

As shown in FIG. 7C, among two adjacent rows of array elements of the array A arranged in the first direction, an array element in one row of the two adjacent rows are adjacent to two adjacent array elements in the other row of the two adjacent rows and these three array elements define three vertices of an equilateral triangle.

In FIG. 7C, a plurality of array elements of the array A each are located at a center of a corresponding one of a plurality of equilateral triangles in the array B, and a plurality of array elements of the array B each are located in a center of a corresponding one of a plurality of equilateral triangles in the array A. Alternatively, the array elements of the array A and array B form a honeycomb network arrangement, or the array elements of the array A and array B both form vertices of regular hexagons that are connected in a network arrangement or are located at positions where the vertices of the regular hexagons are located.

In the above views, the acoustic interference structure only has two arrays, i.e. the array A and the array B. However, the acoustic interference structure may have other numbers of arrays, as long as array elements of at least two of the arrays have different sizes.

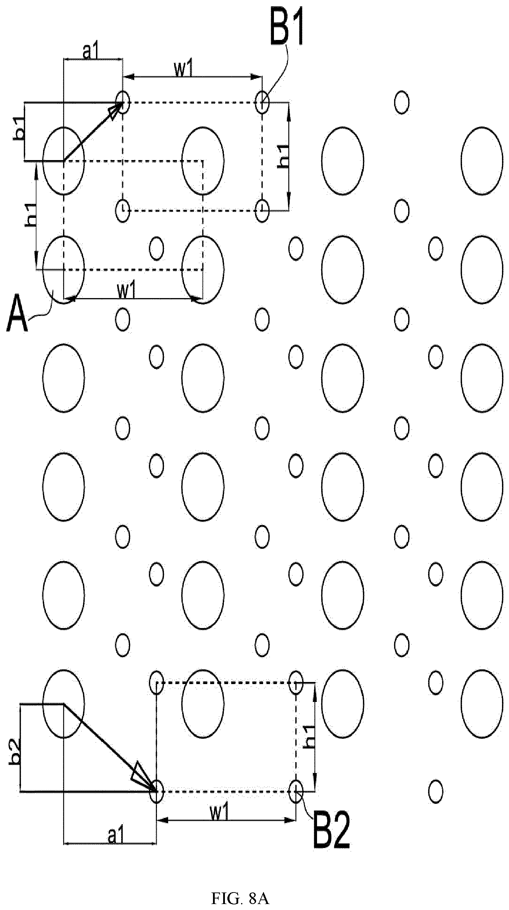

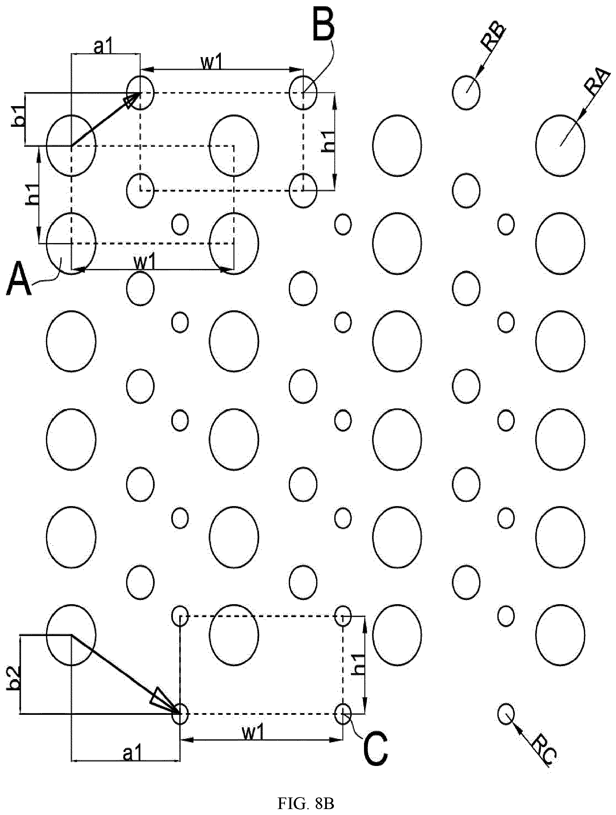

FIG. 8A is a schematic diagram illustratively showing a first array structure, a second array structure and a third array structure that are combined together, and FIG. 8B is a schematic diagram illustratively showing a first array structure, a second array structure and a third array structure that are combined together.

In the array shown in FIG. 8A, elements of subarrays B1 and B2 have a same size, and the subarrays B1 and B2 are translated in different directions and by different distances relative to an array A.

In the array shown in FIG. 8B, elements of subarrays A, B and C have different radii RA, RB and RC, and the subarrays B and C are translated in different directions and by different distances relative to the array A.

In an illustrated example of the present disclosure, a center of an element of the array is a geometric center thereof. For example, a center of a circular array element is a center of the circle, and the centers of the array elements form a point array.

In an illustrated example of the present disclosure, the array elements each have a circular cross-sectional shape, but the present disclosure is not limited to this. For example, the array element may have a rectangular, triangular, and other polygonal cross-sectional shape.

Array elements of the same array can be either protrusions or recesses. All of array elements of different arrays are protrusions or recesses, or a port of array elements of different arrays are protrusions and the remaining part thereof are recesses.

In addition, shapes of different array elements may be the same or different. An expression "same" herein means that cross-sectional shapes of array elements of two arrays are geometrically similar, and an expression "different" means that they are not geometrically similar.

According to the present disclosure, the acoustic interference array is provided such that mismatching degree relative to acoustic impedance of the piezoelectric layer is further improved and a Q value of the resonator is improved.

In addition, when the acoustic interference array is arranged in the effective region, for example, a part of the acoustic interference array arranged in the p1 region can serve as a mass loading structure to adjust the frequency of the resonator. When a part of the array structure arranged in the p1 region includes micro-array structures with two or more dimensions, a parasitic mode generated in the resonator is more effectively suppressed on a basis of adjusting the frequency of the resonator to improve the resonator performance. Specifically, minimum period units of the micro-array structures with two or more dimensions overlap partially, so that the acoustic waves can interfere in the overlapping region, thereby enhancing constraint ability for acoustic waves in a specific frequency range and increasing the Q value of the resonator at this frequency range.

Specifically, the acoustic interference array 70, such as a part located in the effective region, may be a protrusion formed by the material of the top electrode 50 or a recess formed on the top electrode 50. In an embodiment, the acoustic interference array 70 may be a protrusion or a recess formed by the material of the passivation layer 60. In addition, the material of the acoustic interference array 70 may be different from that of the top electrode 50 or the passivation layer 60. For example, when the passivation layer 60 is made of aluminum nitride, the array 70 is made of a material such as silicon dioxide or metal oxide.

A numerical range mentioned in the present disclosure encompass not only end values, but also a median value or other values between the end values, all of which are within the scope of the present disclosure.

As can be understood by those skilled in the art, the bulk acoustic resonator according to the present disclosure may be configured to form a filter.

Although the embodiments of the present disclosure have been shown and described, one of ordinary skill in the art appreciates that many variations that are in accordance with the present teachings are possible provided they remain within the scope of the appended claims.

## Claims

1. A bulk acoustic wave resonator, comprising:
a substrate (10);
an acoustic mirror (20);
a bottom electrode (30);
a top electrode (50); and
a piezoelectric layer (40) provided between the bottom electrode (30) and the top electrode (50),
wherein the top electrode, the piezoelectric layer (40), the bottom electrode (30) and the acoustic mirror (20) overlap with each other in a thickness direction of the resonator to form an overlapping region, and the overlapping region is an effective region of the resonator;
wherein an edge of the effective region of the resonator is provided with an acoustic mismatch structure which is a border ring providing an acoustic mismatch at the perimeter of the upper electrode; and
wherein a top surface of the resonator is provided with an acoustic interference array (70) which is an array of protrusions or recesses, and the acoustic interference array (70) comprises a central array covering the effective region and a peripheral array covering at least part of the acoustic mismatch structure;
**characterized in that** at least one of the central array and the peripheral array comprises at least two types of array structures, the at least two types of array structures comprise a first array structure and a second array structure;
centers of first array elements of the first array structure form a first point array, centers of second array elements of the second array structure form a second point array, the second point array is a point array obtained by planar rotation or planar translation relative to the first point array, and adjacent array elements of the first array elements and the second array elements are spaced apart from each other; and
the first array elements have a size different from a size of the second array elements.

2. The resonator according to claim 1, wherein the acoustic mismatch structure comprises at least one of a recess structure (g1), a protrusion structure (b1), a wing structure, and a bridge structure;
and optionally, the acoustic mismatch structure comprises the recess structure (g1), the protrusion structure (b1), the wing structure, and the bridge structure; and the recess structure (g1) and the protrusion structure (b1) are arranged between the effective region and the wing structure and between the effective region and the bridge structure, the wing structure is arranged at a non-lead out end of the top electrode, and the bridge structure is arranged at a lead out end of the top electrode.

3. The resonator according to claim 2, wherein the recess structure (g1) forms an annular recess surrounding the effective region;
the protrusion structure (b1) forms an annular protrusion surrounding the effective region;
an ascending inclined portion of the wing structure (a1) and an ascending inclined portion of the bridge structure (c1) form an annular ascending inclined portion surrounding the effective region; and
a horizontal portion of the wing structure (a2) and a horizontal portion of the bridge structure (c2) form an annular horizontal portion surrounding the effective region;
wherein ascending refers to the direction of extending from the bottom electrode to the top electrode.

4. The resonator according to claim 2 or 3, wherein the peripheral array covers at least one of the recess structure (g1), the protrusion structure (b1), the wing structure, and the bridge structure.

5. The resonator according to claim 3, wherein the peripheral array comprises a first array, a second array, a third array, and a fourth array that cover the annular recess, the annular protrusion, the annular ascending inclined portion, and the annular horizontal portion, respectively;
and optionally, the effective region is in a shape of polygon, and the annular recess, the annular protrusion, the annular ascending inclined portion and the annular horizontal portion are respectively a first polygonal ring, a second polygonal ring, a third polygonal ring, and a fourth polygonal ring that surround the effective region; each of the polygonal rings comprises vertexes, and in a circumferential direction of the polygonal rings, each of the first array, the second array, the third array and the fourth array is divided into a plurality of trapezoidal regions, the plurality of trapezoidal regions is spaced apart from each other by the vertexes; and an array direction of an array in at least one trapezoidal region of the plurality of trapezoidal regions is parallel to a bottom side of the at least one trapezoidal region;
and optionally, an array direction of an array in each of the plurality of trapezoidal regions is parallel to a bottom side of the trapezoidal region.

6. The resonator according to claim 3, wherein the peripheral array further comprises an array covering a descending inclined portion of the bridge structure; or
the peripheral array further comprises an array covering the descending inclined portion of the bridge structure and an array covering at least a part between the descending inclined portion and an electrode pin;
wherein descending refers to the direction of extending from the top electrode to the bottom electrode.

7. The resonator according to claim 1, wherein the at least two types of array structures further comprise a third array structure;
centers of third array elements of the third array structure form a third point array, the third point array is a point array obtained by planar rotation or planar translation relative to the first point array; and
adjacent array elements of the first array elements, the second array elements and the third array elements are spaced apart from each other.

8. The resonator according to claim 1, wherein a geometry of each of the first array elements is the same as or geometrically similar to a geometry of each of the second array elements; or
a shape of each of the first array elements is different from a shape of each of the second array elements,
and optionally, the shape of the first array element and the shape of the second array element have both a circular section;
and optionally, the array elements are protrusions or recesses; and
and optionally, array elements of a same array structure are protrusions or recesses.

9. The resonator according to claim 1, wherein each of the first point array and the second point array comprises array points that are spaced apart from each other by a first distance in a first direction; and
the array points are spaced apart from each other by a second distance in a second direction perpendicular to the first direction.

10. The resonator according to any one of claims 1 to 6, wherein at least one of the central array and the peripheral array comprises a single array structure.

11. The resonator according to any one of claims 1 to 10, wherein the peripheral array comprises an array which is arranged around the resonator at a periphery of the resonator and which is formed by protrusions and/or recesses.

12. A bulk acoustic wave resonator assembly comprising at least two bulk acoustic wave resonators according to any one of claims 1 to 11, wherein an inter-resonator array is provided between opposite sides of two adjacent bulk acoustic wave resonators of the at least two bulk acoustic wave resonators, and the inter-resonator array is an array formed by protrusions and/or recesses,
and optionally, the two adjacent bulk acoustic wave resonators are both the resonator according to claim 11, and the peripheral acoustic interference array is at least part of the inter-resonator array.

13. A filter comprising the bulk acoustic wave resonator according to any one of claims 1 to 11 or the bulk acoustic wave resonator assembly according to claim 12.

14. An electronic device comprising the filter according to claim 13, the bulk acoustic wave resonator according to any one of claims 1 to 11, or the bulk acoustic wave resonator assembly according to claim 12.

## Patentansprüche

1. Ein Volumenwellenresonator, umfassend:
ein Substrat (10);
einen akustischen Spiegel (20);
eine Bodenelektrode (30);
eine obere Elektrode (50); und
eine piezoelektrische Schicht (40), die zwischen der unteren Elektrode (30) und der oberen Elektrode (50) vorgesehen ist,
wobei die obere Elektrode, die piezoelektrische Schicht (40), die untere Elektrode (30) und der akustische Spiegel (20) in einer Dickenrichtung des Resonators miteinander überlappen, um einen Überlappungsbereich zu bilden, und der Überlappungsbereich ein wirksamer Bereich des Resonators ist;
wobei ein Rand des wirksamen Bereichs des Resonators mit einer akustischen Fehlanpassungsstruktur versehen ist, bei der es sich um einen Randring handelt, der eine akustische Fehlanpassung am Umfang der oberen Elektrode bereitstellt; und
wobei eine Oberseite des Resonators mit einer akustischen Interferenzanordnung (70) versehen ist, die eine Anordnung von Vorsprüngen oder Vertiefungen darstellt, und die akustische Interferenzanordnung (70) eine zentrale Anordnung, die den wirksamen Bereich abdeckt, und eine periphere Anordnung umfasst, die zumindest einen Teil der akustischen Fehlanpassungsstruktur abdeckt;
**dadurch gekennzeichnet, dass** mindestens eines der zentralen Arrays und der peripheren Arrays mindestens zwei Arten von Array-Strukturen umfasst, wobei die mindestens zwei Arten von Array-Strukturen eine erste Array-Struktur und eine zweite Array-Struktur umfassen;
die Mittelpunkte der ersten Anordnungselemente der ersten Anordnungsstruktur ein erstes Punktarray bilden, die Mittelpunkte der zweiten Anordnungselemente der zweiten Anordnungsstruktur ein zweites Punktarray bilden, wobei das zweite Punktarray ein Punktarray ist, das durch planare Drehung oder planare Translation relativ zum ersten Punktarray erhalten wird, und benachbarte Anordnungselemente der ersten Anordnungselemente und der zweiten Anordnungselemente voneinander beabstandet sind; und
die ersten Array-Elemente eine Größe aufweisen, die sich von der Größe der zweiten Array-Elemente unterscheidet.

2. Resonator nach Anspruch 1, wobei die akustische Fehlanpassungsstruktur mindestens eine der folgenden Strukturen umfasst: eine Aussparungsstruktur (g1), eine Vorsprungsstruktur (b1), eine Flügelstruktur und eine Brückenstruktur;
und optional umfasst die akustische Fehlanpassungsstruktur die Vertiefungsstruktur (g1), die Vorsprungsstruktur (b1), die Flügelstruktur und die Brückenstruktur; und die Aussparungsstruktur (g1) und die Vorsprungsstruktur (b1) zwischen dem Wirkungsbereich und der Flügelstruktur sowie zwischen dem Wirkungsbereich und der Brückenstruktur angeordnet sind, die Flügelstruktur an einem nicht herausgeführten Ende der oberen Elektrode angeordnet ist und die Brückenstruktur an einem herausgeführten Ende der oberen Elektrode angeordnet ist.

3. Resonator nach Anspruch 2, wobei die Aussparungsstruktur (g1) eine ringförmige Aussparung bildet, die den Wirkbereich umgibt;
die Vorsprungsstruktur (b1) einen ringförmigen Vorsprung bildet, der den Wirkbereich umgibt;
ein ansteigender geneigter Abschnitt der Flügelstruktur (a1) und ein ansteigender geneigter Abschnitt der Brückenstruktur (c1) einen ringförmigen ansteigenden geneigten Abschnitt bilden, der den Wirkbereich umgibt; und
ein horizontaler Abschnitt der Flügelkonstruktion (a2) und ein horizontaler Abschnitt der Brückenkonstruktion (c2) bilden einen ringförmigen horizontalen Abschnitt, der den Wirkbereich umgibt;
wobei "aufsteigend" die Richtung bezeichnet, die sich von der unteren Elektrode zur oberen Elektrode erstreckt.

4. Resonator nach Anspruch 2 oder 3, wobei die Umfangsanordnung mindestens eine der folgenden Strukturen abdeckt: die Aussparungsstruktur (g1), die Vorsprungsstruktur (b1), die Flügelstruktur und die Brückenstruktur.

5. Resonator nach Anspruch 3, wobei die Umfangsanordnung eine erste Anordnung, eine zweite Anordnung, eine dritte Anordnung und eine vierte Anordnung umfasst, die jeweils die ringförmige Vertiefung, den ringförmigen Vorsprung, den ringförmigen aufsteigenden geneigten Abschnitt und den ringförmigen horizontalen Abschnitt abdecken;
und optional weist der Wirkbereich die Form eines Polygons auf, und die ringförmige Aussparung, der ringförmige Vorsprung, der ringförmige ansteigende geneigte Abschnitt und der ringförmige horizontale Abschnitt sind jeweils ein erster polygonaler Ring, ein zweiter polygonaler Ring, ein dritter polygonaler Ring und ein vierter polygonaler Ring, die den Wirkbereich umgeben; jeder der polygonalen Ringe umfasst Eckpunkte, und in Umfangsrichtung der polygonalen Ringe ist jede der ersten Anordnung, der zweiten Anordnung, der dritten Anordnung und der vierten Anordnung in eine Vielzahl von trapezförmigen Bereichen unterteilt, wobei die Vielzahl von trapezförmigen Bereichen durch die Eckpunkte voneinander beabstandet ist; und eine Anordnungsrichtung eines Arrays in mindestens einem der mehreren trapezförmigen Bereiche parallel zu einer Unterseite des mindestens einen trapezförmigen Bereichs verläuft;
und optional ist eine Anordnungsrichtung einer Anordnung in jedem der mehreren trapezförmigen Bereiche parallel zu einer Unterseite des trapezförmigen Bereichs.

6. Resonator nach Anspruch 3, wobei die Umfangsanordnung ferner eine Anordnung umfasst, die einen abfallenden geneigten Abschnitt der Brückenstruktur abdeckt; oder
die Umfangsanordnung ferner eine Anordnung umfasst, die den abfallenden geneigten Abschnitt der Brückenstruktur abdeckt, sowie eine Anordnung, die zumindest einen Abschnitt zwischen dem abfallenden geneigten Abschnitt und einem Elektrodenstift abdeckt;
wobei "abfallend" die Richtung bezeichnet, die sich von der oberen Elektrode zur unteren Elektrode erstreckt.

7. Resonator nach Anspruch 1, wobei die mindestens zwei Arten von Anordnungsstrukturen ferner eine dritte Anordnungsstruktur umfassen;
die Mittelpunkte der dritten Anordnungselemente der dritten Anordnungsstruktur ein drittes Punktarray bilden, wobei das dritte Punktarray ein Punktarray ist, das durch planare Drehung oder planare Translation relativ zum ersten Punktarray erhalten wird; und
benachbarte Anordnungselemente der ersten Anordnungselemente, der zweiten Anordnungselemente und der dritten Anordnungselemente voneinander beabstandet sind.

8. Resonator nach Anspruch 1, wobei eine Geometrie jedes der ersten Anordnungselemente mit einer Geometrie jedes der zweiten Anordnungselemente identisch oder geometrisch ähnlich ist; oder
sich die Form jedes der ersten Array-Elemente von der Form jedes der zweiten Array-Elemente unterscheidet,
und optional weisen die Form des ersten Array-Elements und die Form des zweiten Array-Elements beide einen kreisförmigen Querschnitt auf;
und optional sind die Anordnungselemente Vorsprünge oder Vertiefungen; und
und optional sind Array-Elemente derselben Array-Struktur Vorsprünge oder Vertiefungen.

9. Resonator nach Anspruch 1, wobei sowohl die erste Punktanordnung als auch die zweite Punktanordnung Anordnungspunkte umfasst, die in einer ersten Richtung um einen ersten Abstand voneinander beabstandet sind; und
die Array-Punkte sind in einer zweiten Richtung, die senkrecht zur ersten Richtung verläuft, um einen zweiten Abstand voneinander beabstandet.

10. Resonator nach einem der Ansprüche 1 bis 6, wobei mindestens eines der zentralen Arrays und der peripheren Arrays eine einzelne Arraystruktur umfasst.

11. Resonator nach einem der Ansprüche 1 bis 10, wobei das periphere Array ein Array umfasst, das um den Resonator an einem Umfang des Resonators angeordnet ist und durch Vorsprünge und/oder Vertiefungen gebildet wird.

12. Eine Volumenwellenresonatoranordnung, die mindestens zwei Volumenwellenresonatoren nach einem der Ansprüche 1 bis 11 umfasst, wobei eine Zwischenresonatoranordnung zwischen gegenüberliegenden Seiten von zwei benachbarten Volumenwellenresonatoren der mindestens zwei Volumenwellenresonatoren vorgesehen ist und die Zwischenresonatoranordnung eine durch Vorsprünge und/oder Vertiefungen gebildete Anordnung ist,
und optional sind die beiden benachbarten Volumenwellenresonatoren beide der Resonator nach Anspruch 11, und die periphere akustische Interferenzanordnung ist zumindest ein Teil der Resonator-Zwischenanordnung.

13. Filter, umfassend den Volumenwellenresonator nach einem der Ansprüche 1 bis 11 oder die Volumenwellenresonatoranordnung nach Anspruch 12.

14. Elektronisches Gerät, das den Filter nach Anspruch 13, den Volumenwellenresonator nach einem der Ansprüche 1 bis 11 oder die Volumenwellenresonatoranordnung nach Anspruch 12 umfasst.

## Revendications

1. Résonateur à ondes acoustiques de volume, comprenant:
un substrat (10);
un miroir acoustique (20);
une électrode inférieure (30);
une électrode supérieure (50); et
une couche piézoélectrique (40) disposée entre l'électrode inférieure (30) et l'électrode supérieure (50),
dans lequel l'électrode supérieure, la couche piézoélectrique (40), l'électrode inférieure (30) et le miroir acoustique (20) se chevauchent les uns les autres dans le sens de l'épaisseur du résonateur pour former une région de chevauchement, et la région de chevauchement est une région effective du résonateur;
dans lequel un bord de la région effective du résonateur est muni d'une structure de désadaptation acoustique qui est un anneau de bordure fournissant une désadaptation acoustique au périmètre de l'électrode supérieure; et
dans lequel une surface supérieure du résonateur est pourvue d'un réseau d'interférence acoustique (70) qui est un réseau de saillies ou de creux, et le réseau d'interférence acoustique (70) comprend un réseau central couvrant la région effective et un réseau périphérique couvrant au moins une partie de la structure de désadaptation acoustique;
**caractérisé en ce qu'**au moins l'un parmi le réseau central et le réseau périphérique comprend au moins deux types de structures de réseau, lesdits au moins deux types de structures de réseau comprenant une première structure de réseau et une deuxième structure de réseau;
les centres des premiers éléments de réseau de la première structure de réseau forment un premier réseau de points, les centres des seconds éléments de réseau de la seconde structure de réseau forment un second réseau de points, le second réseau de points est un réseau de points obtenu par rotation plane ou translation plane par rapport au premier réseau de points, et les éléments de réseau adjacents parmi les premiers éléments de réseau et les seconds éléments de réseau sont espacés les uns des autres; et
les premiers éléments de réseau ont une taille différente de celle des seconds éléments de réseau.

2. Le résonateur selon la revendication 1, dans lequel la structure de désadaptation acoustique comprend au moins l'une parmi une structure en creux (g1), une structure en saillie (b1), une structure en aile et une structure en pont;
et, éventuellement, la structure de désadaptation acoustique comprend la structure en creux (g1), la structure en saillie (b1), la structure en aile et la structure en pont; et la structure en creux (g1) et la structure en saillie (b1) sont disposées entre la région effective et la structure en aile et entre la région effective et la structure en pont, la structure en aile est disposée à une extrémité non de sortie de l'électrode supérieure, et la structure en pont est disposée à une extrémité de sortie de l'électrode supérieure.

3. Le résonateur selon la revendication 2, dans lequel la structure en creux (g1) forme un creux annulaire entourant la région effective;
la structure en saillie (b1) forme une saillie annulaire entourant la région effective;
une partie inclinée ascendante de la structure d'aile (a1) et une partie inclinée ascendante de la structure de pont (c1) forment une partie inclinée ascendante annulaire entourant la région effective; et
une partie horizontale de la structure de l'aile (a2) et une partie horizontale de la structure du pont (c2) forment une partie horizontale annulaire entourant la zone effective;
où « ascendant » désigne la direction s'étendant de l'électrode inférieure vers l'électrode supérieure.

4. Le résonateur selon la revendication 2 ou 3, dans lequel le réseau périphérique recouvre au moins l'une parmi la structure en creux (g1), la structure en saillie (b1), la structure en aile et la structure en pont.

5. Le résonateur selon la revendication 3, dans lequel le réseau périphérique comprend un premier réseau, un deuxième réseau, un troisième réseau et un quatrième réseau qui recouvrent respectivement l'évidement annulaire, la saillie annulaire, la partie inclinée ascendante annulaire et la partie horizontale annulaire;
et, de manière facultative, la région effective a la forme d'un polygone, et l'évidement annulaire, la saillie annulaire, la partie inclinée ascendante annulaire et la partie horizontale annulaire sont respectivement un premier anneau polygonal, un deuxième anneau polygonal, un troisième anneau polygonal et un quatrième anneau polygonal qui entourent la région effective;
chacun des anneaux polygonaux comprend des sommets, et dans une direction circonférentielle des anneaux polygonaux, chacun du premier réseau, du deuxième réseau, du troisième réseau et du quatrième réseau est divisé en une pluralité de régions trapézoïdales, la pluralité de régions trapézoïdales étant espacées les unes des autres par les sommets; et une direction de réseau d' e d'un réseau dans au moins une région trapézoïdale de la pluralité de régions trapézoïdales est parallèle à un côté inférieur de ladite au moins une région trapézoïdale;
et, éventuellement, une direction de réseau d'un réseau dans chacune de la pluralité de régions trapézoïdales est parallèle à un côté inférieur de la région trapézoïdale.

6. Le résonateur selon la revendication 3, dans lequel le réseau périphérique comprend en outre un réseau couvrant une partie inclinée descendante de la structure en pont; ou
le réseau périphérique comprend en outre un réseau couvrant la partie inclinée descendante de la structure en pont et un réseau couvrant au moins une partie entre la partie inclinée descendante et une broche d'électrode;
où « descendant » désigne la direction s'étendant de l'électrode supérieure vers l'électrode inférieure.

7. Le résonateur selon la revendication 1, dans lequel les au moins deux types de structures de réseau comprennent en outre une troisième structure de réseau;
les centres des éléments de la troisième structure de réseau forment un troisième réseau de points, le troisième réseau de points étant un réseau de points obtenu par rotation plane ou translation plane par rapport au premier réseau de points; et
les éléments de réseau adjacents des premiers éléments de réseau, des seconds éléments de réseau et des troisièmes éléments de réseau sont espacés les uns des autres.

8. Le résonateur selon la revendication 1, dans lequel la géométrie de chacun des premiers éléments de réseau est identique ou géométriquement similaire à la géométrie de chacun des seconds éléments de réseau; ou
la forme de chacun des premiers éléments du réseau est différente de la forme de chacun des seconds éléments du réseau,
et, éventuellement, la forme du premier élément de réseau et la forme du deuxième élément de réseau ont toutes deux une section circulaire;
et, éventuellement, les éléments de réseau sont des saillies ou des évidements; et
et, éventuellement, les éléments de réseau d'une même structure de réseau sont des saillies ou des évidements.

9. Le résonateur selon la revendication 1, dans lequel chacun du premier réseau de points et du deuxième réseau de points comprend des points de réseau qui sont espacés les uns des autres d'une première distance dans une première direction; et
les points du réseau sont espacés les uns des autres d'une deuxième distance dans une deuxième direction perpendiculaire à la première direction.

10. Le résonateur selon l'une quelconque des revendications 1 à 6, dans lequel au moins l'un parmi le réseau central et le réseau périphérique comprend une structure de réseau unique.

11. Le résonateur selon l'une quelconque des revendications 1 à 10, dans lequel le réseau périphérique comprend un réseau qui est disposé autour du résonateur au niveau d'une périphérie de celui-ci et qui est formé par des saillies et/ou des évidements.

12. Ensemble de résonateurs à ondes acoustiques de volume comprenant au moins deux résonateurs à ondes acoustiques de volume selon l'une quelconque des revendications 1 à 11, dans lequel un réseau inter-résonateurs est prévu entre les côtés opposés de deux résonateurs à ondes acoustiques de volume adjacents parmi les au moins deux résonateurs à ondes acoustiques de volume, et le réseau inter-résonateurs est un réseau formé par des saillies et/ou des évidements,
et, éventuellement, les deux résonateurs à ondes acoustiques de volume adjacents sont tous deux le résonateur selon la revendication 11, et le réseau d'interférence acoustique périphérique constitue au moins une partie du réseau inter-résonateurs.

13. Filtre comprenant le résonateur à ondes acoustiques de volume selon l'une quelconque des revendications 1 à 11 ou l'ensemble de résonateurs à ondes acoustiques de volume selon la revendication 12.

14. Dispositif électronique comprenant le filtre selon la revendication 13, le résonateur à ondes acoustiques de volume selon l'une quelconque des revendications 1 à 11, ou l'ensemble de résonateurs à ondes acoustiques de volume selon la revendication 12.
